# NEUE EUROPÄISCHE PATENTSCHRIFT

(11) **EP 2 029 946 B2**
(45) Veröffentlichungstag und Bekanntmachung des Hinweises auf die Entscheidung über den Einspruch: **20.09.2017**
(45) Hinweis auf die Patenterteilung: 16.05.2012
(21) Anmeldenummer: 07764365.8
(22) Anmeldetag: 11.06.2007
(51) Int. Cl.: F24J 2/52

(54) **MONTAGESYSTEM INSBESONDERE FÜR SOLARMODULE**
MOUNTING SYSTEM, IN PARTICULAR FOR SOLAR MODULES
SYSTÈME DE MONTAGE, EN PARTICULIER POUR MODULES SOLAIRES

(30) Priorität: 15.06.2006 DE 202006009871 U; 07.06.2007 DE 202007007976 U
(43) Veröffentlichungstag der Anmeldung: 04.03.2009
(73) Patentinhaber: Mounting Systems GmbH, 15834 Rangsdorf (DE)
(72) Erfinder: GENSCHOREK, Gido, 16303 Schwedt (DE); BARTELT-MUSZYNSKI, Sven, 16303 Schwedt (DE)
(74) Vertreter: Eisenführ Speiser
(86) Internationale Anmeldenummer: PCT/DE2007/001048
(87) Internationale Veröffentlichungsnummer: WO 2007/143983

(56) Entgegenhaltungen:
- EP-A- 1 496 550
- EP-A1- 1 341 240
- EP-A2- 1 767 793
- DE-A1- 3 422 049
- DE-A1- 10 132 557
- DE-A1- 19 830 784
- DE-A1-102004 044 103
- DE-C1- 10 152 354
- DE-U1-202005 001 469
- DE-U1-202005 019 924
- FR-A- 2 668 528
- JP-A- 10 122 125
- US-B1- 6 414 237

## Beschreibung

Die Erfindung betrifft ein Montagesystem für plattenförmige Körper, insbesondere Solarmodule, auf Dächern oder an Wänden von Gebäuden, bei dem ein Tragrahmen aus Montageprofilen mit dem Traggerüst des Daches z.B. mittels Dachhaken oder mit der Wand verbunden wird und auf diesem wiederum die Solarmodule befestigt werden.

Nachdem mit Entwicklungen bei Montagesystemen zur Befestigung von Solarmodulen insbesondere auf Dächern und anderen vorzugsweise geneigten größeren Flächen in hohem Maße der Montageaufwand gesenkt wurde und der Befestigung von Modulen mit unterschiedlichen Dickenabmessungen im Rahmenbereich entsprochen werden konnte, stellt sich die Frage nach der optimalen Nutzung der Festigkeitseigenschaften der eingesetzten Montageprofile neu.

Dabei wurde überraschenderweise festgestellt, dass es sich bei den eingesetzten Montageprofilen aus Aluminium oder Aluminiumlegierungen gewöhnlich um "geöffnete" Profile handelt, d.h. eine Vielzahl von Stegen zu einem Träger zusammengesetzt sind oder Verformungen von Profilflächen in das innere von Hohlprofilen reichen, so dass entsprechende Befestigungsmittel in diese greifen oder Profilschenkel hintergreifen können und so ein Gegenlager zum Fixieren der Solarmodulrahmen einerseits und von Dachhaken andererseits finden.

Vielfach handelt es sich dabei um nach innen gekröpfte U-Profile (DE 34 23 227 A1), um L-Profile mit zusätzlichen Auflageflächen (DE 195 35 104 A1), Kombinationen aus U-Profilen (DE 101 52 354 C1) oder reinen Spezialprofilen (DE 101 32 557 A1, DE 10 2005 001 654 B3).

Derartige Profile haben wesentliche Nachteile. Sie bleiben bezüglich der Festigkeitseigenschaften oft hinter klassischen Kastenprofilen zurück. Die Schenkel oder Stege verbiegen sich leicht bei unsachgemäßer Belastung z. B. wenn sich der Monteur auf dem Profil abstützt. Beim Transport lassen sich derartige Spezialprofile schlecht bündeln und sicher ist der Herstellungspreis auch höher als bei einfachen Profilen.

Aus der DE 20 2005 019 924 U1 ist ein Montageschienensystem bekannt, dessen Tragschienen die Form eines Strangprofils mit einem kastenförmigen Innenprofil aufweisen. Das Strangprofil besitzt mindestens einen axial verlaufenden Längsschlitz, in den eine Befestigungsschraube für das Montageelement ohne Gewinde direkt eingeschraubt wird und sich selbst ihr Gewinde schneidet. Das Montageelement besitzt Falze oder Krallen, die einem Auseinanderdrücken der Längsschlitze beim Eindrehen der Befestigungsschraube entgegenwirken. Die Längsschlitze sind dabei gebildet durch beabstandet auf dem Umfang des Innenprofils ausbildete kleinere kastenförmige Profile. Ferner können die Längsschlitze axial verlaufende Vertiefungen zum vorläufigen Einklicken des Montageelementes vor dessen Befestigung durch die Befestigungsschraube aufweisen.

In der DE 10 2004 044 103 B4 werden zur Befestigung von Solarmodulen an Trägerprofilen Modul-Schraubklemmen vorgeschlagen, welche einen U-förmigen Klemmbügel aufweisen, dessen beide Seitenschenkel im Bereich ihrer freien Enden mit Hakenelementen zum Einhängen in das jeweilige Trägerprofil versehen sind und dessen Verbindungsschenkel eine Gewindebohrung aufweist, in die eine Spannschraube einschraubbar ist, von deren Kopf eine Klemmplatte gegen die Oberseite eines zu klemmenden Solarmoduls andrückbar ist. Beschrieben wird als Trägerprofil ein I-Profil, wobei auch Rechteckprofile verwendbar sein sollen.

In der EP 1 341 240 A1 wird ein Montagesystem für Solarmodule beschrieben, bei dem Rechteckprofile als Auflage für Module und Rechteckprofile mit seitlichen Stegen zur Aufnahme von Solarmodulenden genutzt werden.

Aufgabe der Erfindung ist es, ein geschlossenes Profil mit optimalen Festigkeitseigenschaften zum Einsatz zu bringen, das die erreichten Fortschritte für eine rationelle Montage auf schrägen Dächern oder Flächen einschließt.

Gelöst wird diese Aufgabe mit den Merkmalen des Anspruches 1, vorteilhafte Ausgestaltungen sind Gegenstand der Untersprüche.

Das erfindungsgemäße Montagesystem insbesondere für Solarmodule besteht aus Trägern mit einem geschlossenen Hohlkastenträgerprofil mit Anschlüssen für Solarmodulbefestigungsmittel und Anschlüssen für Dachbefestigungsmittel, wobei mindestens die Anschlüsse für die Solarmodulbefestigungsmittel gebildet sind aus beabstandet voneinander angeordneten Längsnut paaren im Hohlkastenträgerprofil und die Befestigungsmittel für den oder die Solarmodule im Trägerbereich aus einem Spannteil mit Formstück bestehen, wobei jedes Formstück mindestens zwei gegenüberliegend am Formstück angeordnete Stege aufweist, über deren vom Formstück entfernt befindlichen Enden eine mindestens formschlüssige Klickverbindung mit einer der Nut paarungen herstellbar ist und das Formstück mindestens eine Bohrung aufweist zur Aufnahme eines Befestigungs bolzens.

Die Herstellung der Klickverbindung erfolgt durch

Aufklicken, bei dem ein kurzzeitiges Aufweiten des Stegabstandes erfolgt, nachstehend Auf-Click-System genannt.

Eine Bewegung des Formstückes in Richtung zur Trägerachse wird durch diesen Formschluss verhindert. Der Formschluss kann natürlich auch mit einem Kraftschluss bei entsprechender Nutausbildung gepaart sein.

Beim Auf-Click-System sind die Anschlüsse für die Solarmodulbefestigungsmittel somit als beabstandet angeordnetes durchgehendes Längsnutpaar im Trägerprofil ausgebildet und die gegenüberliegend am Formstück angeordneten Stege greifen mit ihren vom Formstück entfernt befindlichen Enden jeweils in eine Längsnut des Längsnutpaares des Trägers ein.

Analog sind in einer bevorzugten Ausführung die Anschlüsse für die Dachbefestigung ausgebildet.

So lassen sich Längsnute bei entsprechender Anordnung jeweils zum Aufklicken von Spannteilen der Dachbefestigung und der Solarmodulbefestigung nutzen. Das ist ein weiterer Vorteil.

Im Gegensatz zu den herkömmlichen Profilen bleibt das Trägerprofil als Hohlkammer geschlossen, bevorzugt innen auch in der Kastenprofilierung. Das bedeutet, dass die Längsnute in der Profilwand angeordnet sind, die dazu natürlich über eine entsprechende Dicke verfügen muss. Bei gleicher Festigkeit ist so eine Materialreduzierung gegenüber Profilen des Standes der Technik um 30-40% erreichbar.

Bei einem Trägerprofil mit einem Rechteck- oder Quadratquerschnitt ist vorgesehen, dass sich die Längsnute beim Auf-Click-System jeweils in einer Profilfläche und im Bereich der beiden Seitenkanten oder in gegenüberliegenden Profilflächen jeweils im Bereich der Seitenkanten oder in benachbarten Profilflächen befinden.

Eine weitere vorteilhafte Ausgestaltung sieht vor, dass das Trägerprofil einen 6- oder 8-eckigen Querschnitt aufweist, wobei im Vergleich zu einem Rechteck- oder Quadratprofil die Kanten oben oder oben und unten als Kantenflächen ausgebildet sind. Dabei sollte die Länge der Kantenflächen kürzer als die der verbleibenden Rechteck- oder Quadratprofillängen sein.
Die Längsnute lassen sich dabei in den Kantenflächen anordnen, vorzugsweise in jeder Kantenfläche eine Längsnut, vorzugsweise ein- oder beidseitig als Schwalbenschwanzführung ausgebildet. Hier bietet sich die Nutzung der Längsnute zum Auf klicken von Spannteilen der Dachbefestigung und der Solarmodulbefestigung förmlich an.

Bei in den Kantenflächen angeordneter Längsnut besteht die Möglichkeit, den Profilquerschnitt im Bereich der Kantenflächen verstärkt auszubilden, die Profildicke einfach zu vergrößern. So lassen sich bei dünnwandigen Kastenprofilen auch größere Nuttiefen realisieren.

Der durch das Abflachen der Kanten entstehende Raum kann durch die in die Nute greifenden Befestigungsmittel genutzt werden, ohne dass diese die Profilaußenmaße seitlich z. B. bei obiger Befestigung des Solarmoduls überragen. Die Profile können somit bündig seitlich mit anderen Bauteilen abschließen.

Über die im Formstück vorhandene Bohrung, vorzugsweise eine Gewindebohrung erfolgt die Anbindung des Rahmens des Solarmoduls oder die des Dachhakens, je nachdem ob das Spannteil oben oder seitlich auf dem Träger angeordnet ist.

Das Spannteil aus einem Formstück mit Stegen kann auch zur Herstellung einer Anschlussverbindung zum Träger z.B. in Form eines weiteren Trägers zur Verlängerung des ersten Trägers genutzt werden. Dazu weist der in das Formstück einschraubbare Befestigungsbolzen einen Bohransatz auf, mit dem er das Trägerprofil bevorzugt durchdringt und in ein in das Trägerprofil eingeschobenes Trägerprofilverbindungsstück mindestens eindringt und dieses so fixiert. Auf das herausragende Trägerprofilverbindungsstück wird ein neuer Träger aufgeschoben und in gleicher Weise fixiert. Diese Anordnung ist lösbar.
Möglich sind aber auch beim Verspannen erzielte bleibende Verformungen der beiden Träger mit dem Trägerprofilverbindungsstück, so dass Formschluss entsteht.

Ausführungsbeispiele sind in der Zeichnung dargestellt.

Es zeigen:
- **Fig. 1:**: ein Kastenprofil in der Auf-Click-Ausführung und
- **Fig. 2:**: eine Anschlussverbindung für den Träger.

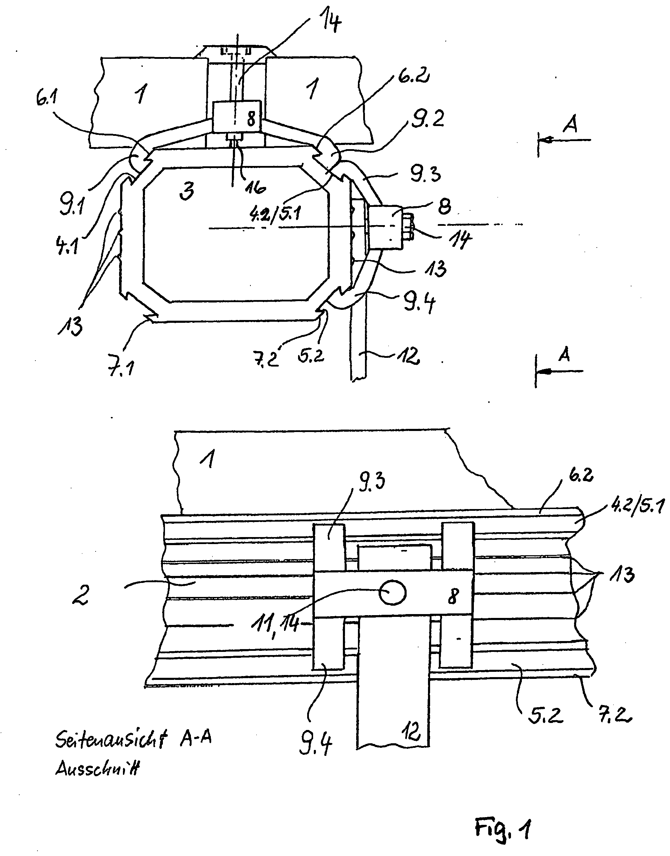

**Fig. 1** zeigt als Auf-Click-System einen Träger 2 mit Trägerprofil 3 in Form eines Quadratprofils mit abgeflachten Ecken, die als Kantenflächen 6.1, 6.2 oben und 7.1 und 7.2 unten bezeichnet werden. In jeder Kantenfläche ist hier mittig eine Längsnut 4, 5 in Trägerlängsrichtung angeordnet, beidseitig als Schwalbenschwanzführung ausgebildet. Das Quadratprofil ist geschlossen und verfügt so über optimale Festigkeitseigenschaften. Die Herstellung inklusive der Nut 4, 5 kann auf technologisch einfache Weise durch Strangpressen erfolgen. Durch Ablängen lassen sich handhabbare Trägerlängen realisieren. Der Transport ist durch die optimale Stapelbarkeit rationell. Das Profil bietet darüber hinaus keine höheren Ansätze, die infolge von Trittbelastungen verformbar sind. Bereits montierte Träger können also bei der Montage durch die Monteure als Trittfläche genutzt werden.

Zur Befestigung des Trägers 2 auf einem Dach mittels Dachhaken 12 und zur Befestigung der Solarmodule 1 werden auf das Trägerprofil 3 Spannteile aufgeklickt. Die Spannteile bestehen aus einem Formstück 8, das gegenüberliegend mit Stegen 9 versehen ist, deren vom Formstück 8 entfernt befindliches Ende in die jeweilige Längsnut 4, 5 form- und/oder kraftschlüssig eingreift.

In der dargestellten Ausführung sind die oben angeordneten Formstücke 8 für die Solarmodulbefestigung mit jeweils einem Steg 9.1, 9.2 auf jeder Seite versehen und die seitlich für die Dachhakenbefestigung angeordneten Formstücke 8 beidseitig jeweils mit einem Paar Stege 9, die zueinander beabstandet angeordnet sind. Die Stegenden sind einerseits form- und/oder kraftschlüssig in der Längsnut 4.2/5.1 verankert. Die Längsnut 4.2/5.1 ist hier eine Nut und Bestandteil des Längsnutpaares 4.1-4.2 und 5.1-5.2. Auf der anderen Seite der Formstücke 8 befindliche Stege 9.1 und 9.4 greifen in die Längsnut 4.1 bzw. 5.2 form- und/oder kraftschlüssig.

Die Verwendung paarweise und beabstandet zueinander angeordneter Stege 9 hat vor allem für die Dachhakenbefestigung Bedeutung. Das Anschlussteil des Dachhakens lässt sich so zwischen den Stegen 9 einer Seite in den Schlitz zwischen Formstück 8 und Träger 2 schieben und durch einen Befestigungsbolzen 14 im Formstück 8 gegen den Träger 2 pressen. Dabei verkrallen sich die Enden der Stegpaare 9.3, 9.4 in den Längsnuten 4.2/5.1 und 5.2.

Durch eine Längsverzahnung 13 des Trägers 2 wird es ermöglicht, dass das Anschlussteil des Dachhakens 12, der im Bereich der Befestigung analog Aussparungen oder Erhebungen aufweist, zusätzlich zum Kraftschluss auch noch formschlüssig mit den Träger 2 verbunden wird. Ein Verschieben in der Senkrechten zum Dach wird so ausgeschlossen. Die Längsverzahnung 13 des Trägers 2 kann einfach (eine Verzahnung) ausgeführt sein, wenn der Anschlussteil des Dachhakens 12 mehrere analoge Aussparungen oder Erhebungen bezogen auf die Höhe aufweist. Natürlich ist dies auch umgekehrt möglich oder beide Teile weisen mehrere eine Paarung bildende Erhebungen und Aussparungen auf. Die Längsverzahnung 13 des Trägers 2 ist wiederum von Vorteil bei der Herstellung im Strangpressverfahren, lässt sie sich doch bei der Pressung des Trägers 2 mit herstellen. Längsverzahnung 13 im verwendeten Sinn kann sowohl Rille als auch vorstehender Zahn im Trägerprofil 3 sein.

Wie ersichtlich, überragen die auf den Kantenflächen 6.1, 6.2, 7.2 auf geklickten Stege 9 die äußere Profilbegrenzung nicht, so dass seitlich sichtbar ein glatter Träger 2 vorhanden ist und auch keine anderweitige seitliche Anschlussmontage behindert wird. Auch das ist ein wesentlicher Vorteil des vorgeschlagenen Montagesystems.

Die Formstücke 8 weisen eine in Richtung Trägerprofil 3 weisende Gewindebohrung 11 auf, über die die Befestigung des Solarmoduls 1 oder des Dachhakens 12 mittels eines Befestigungsbolzens herstellbar ist.

Bei der Solarmodulbefestigung werden die Formstücke 8 zwischen den Solarmodulrahmen etwas nach oben bewegt, wodurch sich die Stege 9 ebenfalls fest in die Längsnute 4.1, 4.2/5.1 einkrallen und die Solarmodule 1 mit ihrem Rahmen auf das Trägerprofil 3 gepresst werden. Weist bei einer Verschraubung der Befestigungsbolzen 14 noch einen Bohransatz 16 auf, ist eine zusätzliche Fixierung im Trägerprofil 3 durch Einbohren oder Durchbohren möglich.

Diese dargestellte Ausführung lässt erkennen, dass neben den bereits genannten Vorteilen des Profils alle Montagearbeiten von oben und nur mit wenigen Handgriffen realisierbar sind. Das ist ein weiterer Vorteil dieser Lösung.

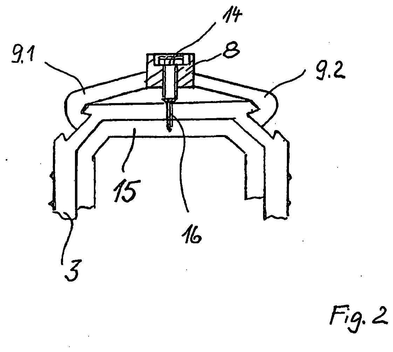

In Fig. 2 ist eine Anschlussverbindung für den Träger 2 mit dem Trägerprofil 3 unter Verwendung eines Formstückes 8 mit Schenkeln 9 gezeigt. Das Formstück 8 mit seinen Schenkeln 9.1, 9.2 ist auf das Trägerprofil 3 aufgeklickt. In das Trägerprofil 3 ist ein Trägerprofilverbindungsstück 15 eingeschoben.

Der in das Formstück 8 einschraubbare Befestigungsbolzen 14 weist einen Bohransatz 16 auf, mit dem er das Trägerprofil 3 durchdringt und in das eingeschobene Trägerprofilverbindungsstück 15 mindestens eindringt und dieses so fixiert.

Nun kann auf das Trägerprofilverbindungsstück 15 ein weiterer Träger 2 aufgeschoben werden und mittels eines weiteren Spannteils mit Formstück 8 in analoger Weise mit diesem verbunden werden.

Auch diese Arbeiten sind von oben realisierbar und bedürfen keines großen Aufwandes. Der Befestigungsbolzen wird im Formstück 8 versenkt, so dass die Trägerverlängerung andere Montageschritte in keinster Weise behindert.

Ohne Übertreibung lässt sich sagen, dass mit der vorgeschlagenen Profilvariante auf Basis eine Hohlkastenprofils mit aufklickbaren Spannteilen der Schritt weg von kostenintensiven Spezialprofilen hin zum einfachen Profil konsequent und nachhaltig vollzogen wurde. Die Montage ist optimal auf Dächern realisierbar, da mit einem Auf- klicken des Spannteiles, das vorab mit dem Befestigungsbolzen und ggf. einem Modulhalter bestückt sein kann, und dem Festziehen des Befestigungsbolzens die wesentlichen Arbeitsschritte getan sind.

### Bezugszeichenliste

- 1: Solarmodul
- 2: Träger
- 3: Trägerprofil geschlossen
- 4: Anschlüsse für Solarbefestigungsmittel
- 4.1: Längsnutpaar
- 4.2: Längsnutpaar
- 5: Anschlüsse für Dachbefestigung
- 5.1: Längsnutpaar
- 5.2: Längsnutpaar
- 6: Kantenfläche oben
- 6.1: Kantenflächen links oben
- 6.2: Kantenflächen rechts oben
- 7.: Kantenflächen unten
- 7.1: Kantenflächen links unten
- 7.2: Kantenflächen rechts unten
- 8: Formstück )Spannteil
- 9: Stege am Formstück )Spannteil
- 11: Bohrung im Formstück )Spannteil
- 12: Dachhaken mit Anschlussteil
- 13: Längsverzahnung
- 14: Befestigungsbolzen
- 15: Trägerprofilverbindungsstück
- 16: Bohransatz am Befestigungsbolzen

## Patentansprüche

1. Montagesystem umfassend Träger und
Solarmodulbefestigungsmittel, wobei die Träger (2) ein geschlossenes Hohlkastenträgerprofil (3) mit Anschlüssen (4) für Solarmodulbefestigungsmittel und mit Anschlüssen (5) für Dachbefestigungsmittel aufweisen und die Befestigungsmittel für den oder die Solarmodule (1) über Stege (9.1, 9.2) verfügen, mittels derer eine Verbindung zu den Anschlüssen (4) herstellbar ist und die Befestigungsmittel gegenüber dem Träger (2) fixierbar sind, wobei die Befestigungsmittel für den oder die Solarmodule (1) im Trägerbereich aus einem Spannteil mit Formstück (8) bestehen und die Stege (9.1, 9.2) gegenüber am Formstück (8) angeordnet sind, wobei das Formstück (8) eine in Richtung Hohlkastenträgerprofil (3) weisende Bohrung (11) aufweist, über die die Befestigung des Solarmoduls (1) mittels eines Befestigungsbolzens (14) herstellbar ist, wobei
die Anschlüsse (4) für die Solarmodulbefestigungsmittel als beabstandet angeordnetes Längsnutpaar (4.1 - 4.2) im Hohlkastenträgerprofil (3) ausgebildet sind und die Stege (9.1, 9.2) mit ihren vom Formstück (8) entfernt befindlichen Enden jeweils in eine Längsnut des Längsnutpaares (4.1 - 4.2) jeweils durch Aufklicken, bei dem ein kurzzeitiges Aufweiten des Stegabstandes stattfindet, mindestens formschlüssig greifen,
wobei bei der Solarmodulbefestigung nach dem Greifen mittels eines Aufklickens in ein Längsnutpaar (4.1 - 4.2) das Formstück (8) zwischen den Solarmodulrahmen etwas nach oben bewegbar ist, wobei die Solarmodule (1) mit ihrem Rahmen auf das Hohlkastenträgerprofil (3) gepresst werden und die Stege (9.1, 9.2) sich fest in die Längsnute (4.1, 4.2) einkrallen.

2. Montagesystem nach Anspruch 1 **dadurch gekennzeichnet, dass**
die Anschlüsse (5) für die Dachbefestigung als beabstandet angeordnetes durchgehendes Längsnutpaar (5.1, 5.2) im Trägerprofil (3) ausgebildet sind, in die mindestens formschlüssig die Befestigungsmittel für die Dachbefestigung (12) greifen, die in gleicher Weise wie die Spannteile für die Solarmodulbefestigung ausgebildet sind.

3. Montagesystem nach Anspruch 1 oder 2, **dadurch gekennzeichnet, dass**
Längsnute sowohl zum Aufklicken von Spannteilen der Dachbefestigung als auch für Spannteile der Solarmodulbefestigung nutzbar sind.

4. Montagesystem nach einem der Ansprüche 1 bis 3, **dadurch gekennzeichnet, dass**
das Trägerprofil (3) ein Rechteck- oder Quadratkastenprofil ist und sich die Längsnute der Längsnutpaare (4.1 - 4.2) oder (5.1 - 5.2) jeweils auf oder in einer Profilfläche und im Bereich der beiden Seitenkanten oder jeweils auf öder in gegenüberliegenden Profilflächen jeweils im Bereich der Seitenkanten oder jeweils auf oder in benachbarten Profilflächen befinden.

5. Montagesystem nach einem der Ansprüche 1 bis 3, **dadurch gekennzeichnet, dass**
das Trägerprofil (3) einen 6- oder 8-eckigen Kastenquerschnitt aufweist, gebildet dadurch, dass die Kanten eines Rechteck- oder Quadratprofils als Kantenflächen (6.1, 6.2) oben und soweit benötigt als Kantenflächen unten (7.1, 7.2) ausgebildet sind und hier jeweils Längsnute angeordnet sind.

6. Montagesystem nach Anspruch 5, **dadurch gekennzeichnet, dass**
die Länge der Kantenflächen (6.1, 6.2, 7.1,7.2) kürzer ist als die der verbleibenden Rechteck- oder Quadratprofillängen.

7. Montagesystem nach Anspruch 5 oder 6, **dadurch gekennzeichnet, dass**
bei in den Kantenflächen (6, 7) angeordneter Längsnut (4, 5) der Profilquerschnitt im Bereich der Kantenflächen (6, 7) verstärkt ausgebildet ist.

8. Montagesystem nach einem der Ansprüche 1 bis 7, **dadurch gekennzeichnet, dass**
die Längsnute (4, 5) eine ein- oder beidseitig ausgebildete Schwalbenschwanzführung aufweisen.

9. Montagesystem nach einem der Ansprüche 1 bis 8, **dadurch gekennzeichnet, dass**
das Formstück (8) auf jeder Seite zwei zueinander beabstandet angeordnete Stege (9) aufweist, oder auf einer Seite einen Steg (9) und auf der anderen Seite zwei Stege (9).

10. Montagesystem nach einem der Ansprüche 1 bis 9, **dadurch gekennzeichnet, dass**
die Bohrung (11) des Formstückes (8) eine Gewindebohrung zur Aufnahme eines Befestigungsbolzens (14) für den Solarmodul (1) oder für das Anschlussteil eines Dachhakens (12) oder für ein Trägerprofilverbindungsstück (15) ist.

11. Montagesystem nach einem der Ansprüche 1 bis 10, **dadurch gekennzeichnet, dass**
der Befestigungsbolzen (14) einen Bohransatz (16) aufweist, der so bemessen ist, dass er in das Trägerprofil (3) eindringen und/oder es durchdringen kann.

12. Montagesystem nach einem der Ansprüche 1 bis 11, **dadurch gekennzeichnet, dass**
zur Herstellung einer Verbindung Dachhaken (12) und Träger (2) das Anschlussteil des Dachhakens (12) zwischen zwei benachbarten Stegen (9) in den Spalt zwischen Formstück (8) und Trägerprofil (3) bei aufgeklicktem Spannteil schiebbarist und mittels des Befestigungsbolzens (14) gegen dasTrägerprofil (3) pressbar ist.

13. Montagesystem nach einem der Ansprüche 1 bis 12, **dadurch gekennzeichnet, dass**
Spannteile aus Formstück (8) mit Stegen (9) zur Herstellung einer Anschlussverbindung vom Träger (2) zu einem Träger (2'), einsetzbar sind, in dem in die zu verbindenden Träger (2, 2') ein Trägerprofilverbindungsstück (15) angeordnet ist und beide Träger (2, 2') über Befestigungsbolzen (14) der aufgeklickten Spannteile, die das Trägerprofil (3) jeweils durchdringen und in das Trägerprofilverbindungsstück (15) mindestens eindringen oder das Trägerprofil (3) auf das Trägerprofilverbindungsstück (15) vorzugsweise unter Verformung pressen, miteinander verbindbar sind.

## Claims

1. Mounting system comprising brackets and solar module fastening means, wherein the brackets (2) have a closed hollow box bracket profile (3) with connectors (4) for solar module fastening means and connectors (5) for roof fastening means, and the fastening means for the solar module (1) or for the solar modules (1) have flanges (9.1, 9.2) by means of which a connection with the connectors (4) can be established and the fastening means can be fixed opposite the bracket (2), wherein the fastening means for the solar module (1) or for the solar modules (1) in the area of the bracket consist of a tensioning piece with a molded piece (8) and the flanges (9.1, 9.2) are arranged opposite each other on then molded piece (8), wherein the molded piece (8) has a bore hole (11) via which the solar module (1) can be fastened by means of a fastening bolt (14), said bore hole (11) extending towards the hollow box bracket profile (3), wherein
the connectors (4) for the solar module fastening means are designed as a spaced-apart pair of longitudinal grooves (4.1 -4.2) in the hollow box bracket profile (3) and each of the flange (9.1, 9.2) ends that are distal to the molded piece (8) engages one longitudinal groove of the pair of longitudinal grooves (4.1 - 4.2) by being clicked onto it, said clicking causing a momentary widening of the space between the flanges and said engagement being at least in the form of a positive connection, wherein, when the solar modules are fastened after the engagement by being clicked into a pair of longitudinal grooves (4.1 - 4.2), the molded piece (8) is movable slightly upwards between the solar module frames, wherein the frames of the solar modules (1) are pressed onto the hollow box bracket profile (3) and a firm claw connection between the flanges (9.1, 9.2) and the longitudinal grooves (4.1 4.2) is established.

2. Mounting system according to claim 1, **characterized in that**
the connectors (5) for the roof fastening means are designed as a spaced-apart continuous pair of longitudinal grooves (5.1, 5.2) in the bracket profile (3) that are engaged, at least in the form of a positive connection, by the fastening means for the roof fastening means (12) that are designed in the same manner as the tensioning pieces for the solar module fastening means.

3. Mounting system according to claim 1 or 2, **characterized in that**
longitudinal grooves can be used for clicking tensioning pieces of the roof fastening means onto them as well as for tensioning pieces of the solar module fastening means.

4. Mounting system according to any one of claims 1 to 3, **characterized in that**
the bracket profile (3) is a rectangular or square box profile and the longitudinal grooves of the pairs of longitudinal grooves (4.1 - 4.2) or (5.1 - 5.2) are each located on or in a profile surface and in the region of the two lateral edges, or are each located on or in opposite profile surfaces where they are each located in the region of the lateral edges, or are each located on or in adjacent profile surfaces.

5. Mounting system according to any one of claims 1 to 3, **characterized in that**
the bracket profile (3) has a hexagonal or octagonal box cross-section that is formed by the edges of a rectangular or square profile being designed as edge surfaces (6.1, 6.2) at the top and, if necessary, as edge surfaces at the bottom (7.1, 7.2) and by longitudinal grooves being arranged here in each case.

6. Mounting system according to claim 5, **characterized in that**
the length of the edge surfaces (6.1, 6.2, 7.1, 7.2) is shorter than that of the remaining rectangular or square profile lengths.

7. Mounting system according to claim 5 or 6, **characterized in that**
when the longitudinal groove (4, 5) is arranged in the edge surfaces (6, 7), the profile cross-section in the region of the edge surfaces (6, 7) is enlarged.

8. Mounting system according to any one of claims 1 to 7, **characterized in that**
the longitudinal grooves (4, 5) have a dovetail guide on one side or on both sides.

9. Mounting system according to any one of claims 1 to 8, **characterized in that**
the molded piece (8) has two spaced-apart flanges (9) on each side, or one flange (9) on one side and two flanges (9) on the other side.

10. Mounting system according to any one of claims 1 to 9, **characterized in that**
the bore hole (11) of the molded piece (8) is a threaded bore hole for receiving a fastening bolt (14) for the solar module (1) or for the connecting piece of a roof hook (12) or for a bracket profile connecting piece (15).

11. Mounting system according to any one of claims 1 to 10, **characterized in that**
the fastening bolt (14) has a drilling nose (16) that is dimensioned such that it can penetrate the bracket profile (3) partially and/or fully.

12. Mounting system according to any one of claims 1 to 11, **characterized in that** for establishing a connection between the roof hook (12) and the bracket (2), the connecting piece of the roof hook (12) can be pushed, when the tensioning piece is clicked on, between two adjacent flanges (9) into the gap between the molded piece (8) and the bracket profile (3) and can be pressed against the bracket profile (3) by means of the fastening bolt (14).

13. Mounting system according to any one of claims 1 to 12, **characterized in that** tensioning pieces consisting of a molded piece (8) with flanges (9) can be used for establishing a connection between the bracket (2) and a bracket (2'), wherein a bracket profile connecting piece (15) is arranged in the brackets (2, 2') to be connected and both brackets (2, 2') can be connected with each other by means of fastening bolts (14) of the clicked-on tensioning pieces that each fully penetrate the bracket profile (3) and at least partially penetrate the bracket profile connecting piece (15) or press the bracket profile (3), preferably by way of deformation, onto the bracket profile connecting piece (15).

## Revendications

1. Système de montage comprenant des supports et des moyens de fixation de modules solaires, les supports (2) présentant un profilé de support en caisson creux (3) fermé, avec des connexions (4) pour des moyens de fixation de modules solaires et des connexions (5) pour des moyens de fixation de toit, et les moyens de fixation pour le ou les modules solaires (1) disposant de nervures (9.1, 9.2) au moyen desquelles un raccordement aux connexions (4) peut être réalisé, et au moyen desquelles les moyens de fixation peuvent être fixés par rapport au support (2), les moyens de fixation pour le ou les modules solaires (1) dans la zone de support se composant d'une partie de serrage avec préformé (8), et les nervures (9.1, 9.2) étant disposées en face l'une de l'autre sur le préformé (8), le préformé (8) présentant un alésage (11) dirigé vers le profilé de support en caisson creux (3) et par le biais duquel la fixation du module solaire (1) peut être réalisée au moyen d'un boulon de fixation (14),
les connexions (4) pour les moyens de fixation de modules solaires étant constituées sous forme de paire de rainures longitudinales (4.1 - 4.2) disposée de façon espacée dans le profilé de support en caisson creux (3), et les nervures (9.1, 9.2) engrenant par encliquetage, au moins par liaison de forme, avec leurs extrémités éloignées du préformé (8), respectivement dans une rainure longitudinale de la paire de rainures longitudinales (4.1 - 4.2), encliquetage au cours duquel il se produit un bref évasement de l'intervalle de nervures, le préformé (8) étant, lors de la fixation du module solaire après avoir engrené au moyen d'un encliquetage dans une paire de rainures longitudinales (4.1 - 4.2), légèrement mobile vers le haut entre les cadres de modules solaires, les modules solaires (1) étant, avec leur cadre, pressés sur le profilé de support en caisson creux (3) et les nervures (9.1, 9.2) s'agrippant fermement dans les rainures longitudinales (4.1, 4.2).

2. Système de montage selon la revendication 1, **caractérisé en ce que**
les connexions (5) pour la fixation de toit sont constitués en tant que paire de rainures longitudinales (5.1, 5.2) continue disposée de façon espacée dans le profilé de support (3), dans lesquelles engrènent, au moins par liaison de forme, les moyens de fixation pour la fixation de toit (12) qui sont constitués de la même façon que les parties de serrage pour la fixation des modules solaires.

3. Système de montage selon la revendication 1 ou la revendication 2, **caractérisé en ce que**
des rainures longitudinales sont utilisables aussi bien pour l'encliquetage de parties de serrage de la fixation de toit que pour des parties de serrage de la fixation de modules solaires.

4. Système de montage selon une des revendications 1 à 3, **caractérisé en ce que** le profilé de support (3) est un profilé en caisson rectangulaire ou carré, et **en ce que** les rainures longitudinales des paires de rainures longitudinales (4.1 - 4.2) ou (5.1 - 5.2) se trouvent respectivement sur ou dans une surface de profilé et dans la zone des deux arêtes latérales, ou respectivement sur ou dans des surfaces de profilé opposées respectivement dans la zone des arêtes latérales, ou respectivement sur ou dans des surfaces de profilé voisines.

5. Système de montage selon une des revendications 1 à 3, **caractérisé en ce que** le profilé de support (3) présente une section en caisson à 6 ou 8 angles, formée **en ce que** les arêtes d'un profilé rectangulaire ou carré sont constituées en tant que rives (6.1, 6.2) en haut et, si cela est nécessaire, en tant que rives (7.1, 7.2) en bas, et **en ce que** des rainures longitudinales ou des nervures longitudinales sont respectivement disposées ici.

6. Système de montage selon la revendication 5, **caractérisé en ce que** la longueur des rives (6.1, 6.2, 7.1, 7.2) est plus courte que les longueurs restantes de profilé rectangulaire ou carré.

7. Système de montage selon la revendication 5 ou la revendication 6, **caractérisé en ce que,**
dans le cas de la rainure longitudinale (4, 5) disposée dans les rives (6, 7), la section de profilé est constituée de façon renforcée dans la zone des rives (6, 7).

8. Système de montage selon une des revendications 1 à 7, **caractérisé en ce que** les rainures longitudinales (4, 5) présentent un guidage en queue d'aronde constitué de façon unilatérale ou bilatérale.

9. Système de montage selon une des revendications 1 à 8, **caractérisé en ce que** le préformé (8) présente sur chaque côté deux nervures (9) disposées de façon espacée l'une de l'autre, ou bien une nervure (9) sur un côté et deux nervures (9) sur l'autre côté.

10. Système de montage selon une des revendications 1 à 9, **caractérisé en ce que** l'alésage (11) du préformé (8) est un alésage fileté destiné à loger un boulon de fixation (14) pour le module solaire (1) ou pour la partie de raccordement d'un crochet de toit (12) ou pour une pièce de raccordement de profilé de support (15).

11. Système de montage selon une des revendications 1 à 10, **caractérisé en ce que** le boulon de fixation (14) présente un appendice de perçage (16) qui est dimensionné de sorte qu'il peut pénétrer dans le profilé de support (3) et/ou le traverser.

12. Système de montage selon une des revendications 1 à 11, **caractérisé en ce que** pour la réalisation d'un raccordement crochet de toit (12) et support (2), la partie de raccordement du crochet de toit (12) peut être poussée entre deux nervures (9) voisines dans l'interstice entre le préformé (8) et le profilé de support (3) quand la partie de serrage est encliquetée et peut être pressée contre le profilé de support (3) au moyen du boulon de fixation (14).

13. Système de montage selon une des revendications 1 à 12, **caractérisé en ce que** des parties de serrage composées du préformé (8) avec des nervures (9) peuvent être mises en oeuvre pour la réalisation d'un raccordement de connexion du support (2) avec un support (2') dans lequel une pièce de raccordement de profilé de support (15) est disposée dans les supports (2, 2') à raccorder, et les deux supports (2, 2') peuvent être raccordés par le biais de boulons de fixation (14) des parties de serrage encliquetées qui traversent respectivement le profilé de support (3) et pénètrent au moins dans la pièce de raccordement de profilé de support (15) ou qui pressent le profilé de support (3) sur la pièce de raccordement de profilé de support (15), de préférence avec déformation.
